# EUROPEAN PATENT APPLICATION

(11) **EP 1 282 116 A1**
(43) Date of publication of application: **05.02.2003**
(21) Application number: 02250685.1
(22) Date of filing: 31.01.2002
(51) Int. Cl.: G11B 5/64, G11B 5/84

(54) **Polycrystalline structure film and method of making same**

(30) Priority: 01.08.2001 JP 2001233159
(71) Applicant: FUJITSU LIMITED, Kawasaki-shi, Kanagawa 211-8588 (JP)
(72) Inventor: Mukai, Ryoichi, c/o Fujitsu Limited, Kawasaki-shi, Kanagawa 211-8588 (JP)
(74) Representative: Stebbing, Timothy Charles

(57) **Abstract**

A method of making a polycrystalline structure film (22) includes causing metallic atoms and compounds to deposit over the surface of a substrate (21). When the metallic atoms and the molecules of the compounds are simultaneously deposited on the substrate (21), fine and smallest metallic nucleation sites (27) can be formed over the surface of the substrate (21) at a higher density per unit area. Subsequent deposition of metallic atoms enables generation of fine and smallest crystal grains (29) consisting of the metallic atoms.

## Description

The present invention relates to a polycrystalline structure film preferably employed in a magnetic recording medium such as a hard disk (HD), for example. In particular, the invention relates to a polycrystalline structure film comprising nucleation sites existing on the surface of a substrate and a crystal layer containing crystal grains having grown from the nucleation sites, and to a method of making the same.

A magnetic polycrystalline film is generally employed in a magnetic recording medium. The magnetic polycrystalline film includes a Cr seed crystal layer formed over the front and back surfaces of a disk substrate, and a Co-based alloy layer or magnetic crystal layer formed based on the epitaxy from the Cr seed crystal layer. As generally known, the minimization of magnetic crystal grains within the Co-based alloy layer leads to a reduction in noise in the reproduction of magnetic information data.

In the case where the Co-based alloy layer is allowed to epitaxially grow on the Cr seed layer, it is impossible to achieve the minimization of the magnetic crystal grains within the Co-based alloy layer unless the crystal grains can be minimized within the Cr seed layer. No specific means have been previously proposed to achieve the minimization of the crystal grains within the Cr seed layer.

It is accordingly desirable to provide a polycrystalline structure film greatly contributing to minimization of crystal grains within a metallic crystal layer.

According to a first aspect of the present invention, there is provided a polycrystalline structure film suitable for use in a magnetic recording medium, comprising: metallic nucleation sites sparsely existing over a surface of a substrate, said metallic nucleation sites including a compound; and a metallic crystal layer covering over the surface of the substrate and containing crystal grains having grown from the metallic nucleation sites.

According to a second aspect of the present invention, there is provided a method of making a polycrystalline structure film, comprising: causing metallic atoms and compounds to deposit over a surface of a substrate.

When the metallic atoms and the molecules of the compound are simultaneously deposited on the substrate, the finest and smallest metallic nucleation sites can be formed over the surface of the substrate at a higher density per unit area. Deposition of metallic atoms after the formation of the metallic nucleation sites enables generation of the finest and smallest crystal grains consisting of the metallic atoms.

The compounds may be metallic compounds, for example. The metallic compounds may include a metallic oxide, such as SiO₂ and Al₂O₃, and/or a metallic nitride, such as Si₃N₄. The metallic atoms may include platinum atoms, for example.

Radio frequency sputtering may be employed to cause the metallic atoms and the compounds to fall over the substrate. In this case, a target of the radio frequency sputtering may comprise a composition of a compact powder ("powder compact") of the metallic atoms and a powder compact of the compounds. The radio frequency sputtering can be utilized to reliably sputter an insulating material target which may comprise a metallic oxide and/or a metallic nitride.

Alternatively, a target of the radio frequency sputtering may comprise a block consisting of the metallic atoms. In this case, chips of the compounds are located on the surface of the block. The content of the compounds within the metallic nucleation sites can easily be determined based on the ratio of the exposed surfaces between the block and the chips.

A so-called co-sputtering may be employed to form the metallic nucleation sites. An electrically conductive target of the metallic atoms may be connected to a direct current (DC) power source, while an insulating target of the compounds may be connected to a radio frequency (RF) or high frequency power source. The output power of the DC power source serves to determine the amount of falling (ejected) metallic atoms, while the output power of the RF power source serves to determine the amount of falling compounds. Adjustment of the output powers leads to an easier management of the content within the metallic nucleation sites.

The aforementioned method serves to provide a polycrystalline structure film according to the first aspect of the present invention.

Fine and small crystal grains can be established in the polycrystalline structure film based on the metallic nucleation sites formed in the aforementioned manner. When the polycrystalline structure film of this type is utilized in a magnetic recording medium, for example, recording tracks can be arranged at a still higher density over the magnetic recording medium. The recording capacity of the magnetic recording medium can be improved. Transition of noise between the adjacent recording tracks can be suppressed to the utmost.

The above and other features and advantages of the present invention will become apparent from the following description of the preferred embodiments in conjunction with the accompanying drawings, wherein:
Fig. 1 is a plan view schematically illustrating the structure of a hard disk drive (HDD) as an example of a magnetic recording medium drive;
Fig. 2 illustrates an enlarged sectional view of a magnetic recording disk according to a specific example of the present invention;
Fig. 3 is a sectional view of a substrate schematically illustrating a method of making the magnetic recording disk;
Fig. 4 is a sectional view of a substrate illustrating the formation of metallic nucleation sites over the surface of the substrate;
Fig. 5 is another sectional view of a substrate illustrating the formation of metallic nucleation sites over the surface of the substrate;
Fig. 6 is a schematic view illustrating the structure of a radio frequency sputtering apparatus;
Fig. 7 is an enlarged perspective view schematically illustrating a target of the sputtering according to a specific example;
Fig. 8 is an enlarged perspective view schematically illustrating a target of the sputtering according to another specific example;
Fig. 9 is a schematic view illustrating the structure of a co-sputtering apparatus;
Fig. 10 is a sectional view of a substrate illustrating the formation of a seed crystal layer over the surface of the substrate;
Fig. 11 is a sectional view of a substrate illustrating the formation of a magnetic crystal layer over the surface of the substrate;
Fig. 12 is a graph illustrating the distribution of the diameters of the metallic nucleation sites according to a specific example of the present invention; and
Fig. 13 is a graph illustrating the distribution of the diameters of the nucleation sites according to a comparative example.

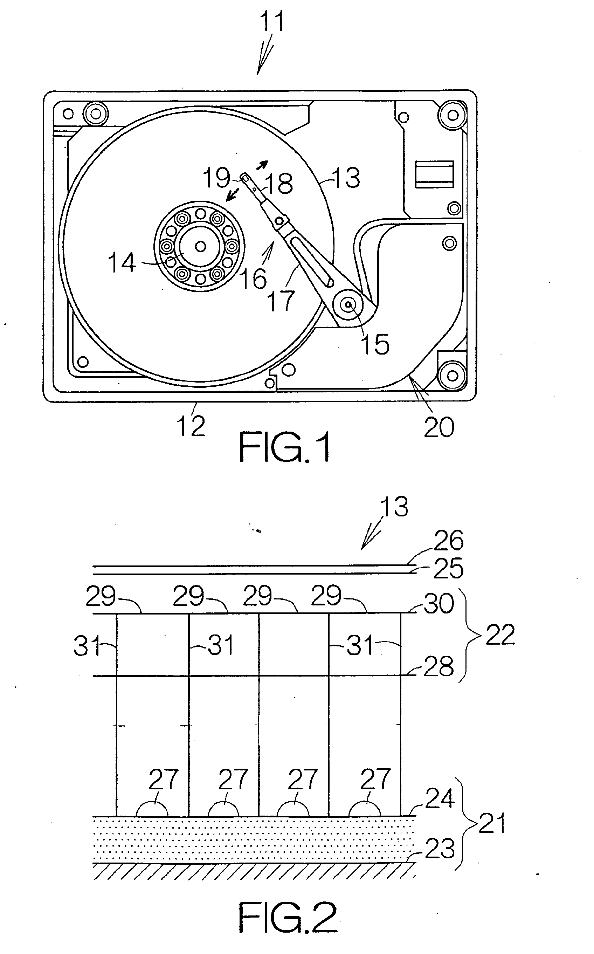

Fig. 1 schematically illustrates the inner structure of a hard disk drive (HDD) 11 as an example of a recording medium drive or storage device. The HDD 11 includes a box-shaped primary enclosure 12 defining an inner space of a flat parallelepiped, for example. At least one magnetic recording disk 13 is accommodated in the inner space within the primary enclosure 12. The magnetic recording disk 13 is mounted on a driving shaft of a spindle motor 14. The spindle motor 14 is allowed to drive the magnetic recording disk 13 for rotation at a high revolution speed, such as 7,200rpm or 10,000rpm, for example. A cover, not shown, is coupled to the primary enclosure 12 so as to define the closed inner space between the primary enclosure 12 and itself.

A carriage 16 is also accommodated in the inner space of the primary enclosure 12 for swinging movement about a vertical support shaft 15. The carriage 16 includes a rigid swinging arm 17 extending in the horizontal direction from the vertical support shaft 15, and an elastic head suspension 18 fixed to the tip end of the swinging arm 17 so as to extend forward from the swinging arm 17. As conventionally known, a flying head slider 19 is cantilevered at the head suspension 18 near the front end through a gimbal spring (not shown). The head suspension 18 serves to urge the flying head slider 19 toward the surface of the magnetic recording disk 13. When the magnetic recording disk 13 rotates, the flying head slider 19 is exposed to airflow generated along the rotating magnetic recording disk 13. The airflow serves to generate a lift on the flying head slider 19. The flying head slider 19 is thus allowed to keep flying above the surface of the magnetic recording disk 13 during rotation of the magnetic recording disk with a higher stability established by the balance between the lift and the urging force of the head suspension 18.

When the carriage 16 is driven to swing about the support shaft 15 during flight of the flying head slider 19, the flying head slider 19 is allowed to cross the recording tracks defined on the magnetic recording disk 13 in the radial direction of the magnetic recording disk 13. This radial movement serves to position the flying head slider 19 right above a target recording track on the magnetic recording disk 13. In this case, an electromagnetic actuator 20 such as a voice coil motor (VCM) can be employed to realize the swinging movement of the carriage 16, for example. As conventionally known, in the case where two or more magnetic recording disks 13 are incorporated within the inner space of the primary enclosure 12, a pair of the elastic head suspensions 18 are mounted on a single common swinging arm 17 between the adjacent magnetic recording disks 13.

Fig. 2 illustrates in detail the structure of the magnetic recording disk 13. The magnetic recording disk 13 includes a substrate 21 as a support member, and layered polycrystalline structure films 22 extending over the front and back surfaces of the substrate 21, respectively. The substrate 21 may comprise a disk-shaped Si body 23 and amorphous SiO₂ laminations 24 covering the front and back surfaces of the Si body 23, for example. A glass or aluminum substrate may be employed in place of the aforementioned substrate 21 type. Magnetic information (data) is recorded in the layered polycrystalline structure films 22. Each layered polycrystalline structure film 22 is covered with a protective carbon overcoat 25 and a lubricating agent film 26.

The layered polycrystalline structure film 22 includes metallic nucleation sites or islands 27 dispersed over the surface of the substrate 21 at a higher density. Each nucleation site 27 may include metallic atoms in the form of Co88Pt12 [at%] alloy and insulating metallic compounds such as SiO₂, for example. The metallic compound may be contained in the nucleation site 27 in a range between 5at% and 20at%, for example. Otherwise, the metallic compound may be a metallic oxide, such as Al₂O₃, a metallic nitride, such as Si₃N₄, or the like.

A seed crystal layer 28 is formed to extend over the surface of the substrate 21. The nucleation sites 27 are contained within the seed crystal layer 28. Fine crystal grains 29 are defined within the seed crystal layer 28 for the respective nucleation sites 27. The seed crystal layer 28 may be made of a pure Cr layer, for example.

A magnetic crystal layer 30 is formed to extend over the surface of the seed crystal layer 28. The magnetic crystal layer 30 is allowed to have the lattice structure identical to that of the seed crystal layer 28. Specifically, the epitaxial relationship is established between the seed crystal layer 28 and the magnetic crystal layer 30. The magnetic crystal layer 30 contains non-magnetic Cr atoms diffusing along grain boundaries 31 defined between the adjacent crystal grains 29. The magnetic crystal layer 30 may be a Co-based alloy layer such as a Co₉₀Pt₁₀ layer, for example.

The layered polycrystalline structure film 22 enables establishment of finer and smaller crystal grains 29 within the seed crystal layer 28 and the magnetic crystal layer 30, as described later in detail. The magnetic recording disk 13 employing the layered polycrystalline structure film 22 thus realizes a significant reduction in transition noise between the adjacent recording tracks defined on the surface of the magnetic recording disk 13. The arrangement of crystal or magnetic grains 29 in the magnetic crystal layer 30 greatly contribute to the arrangement of the recording tracks at a still higher density, in other words, the establishment of a higher recording density in the magnetic recording disk 13.

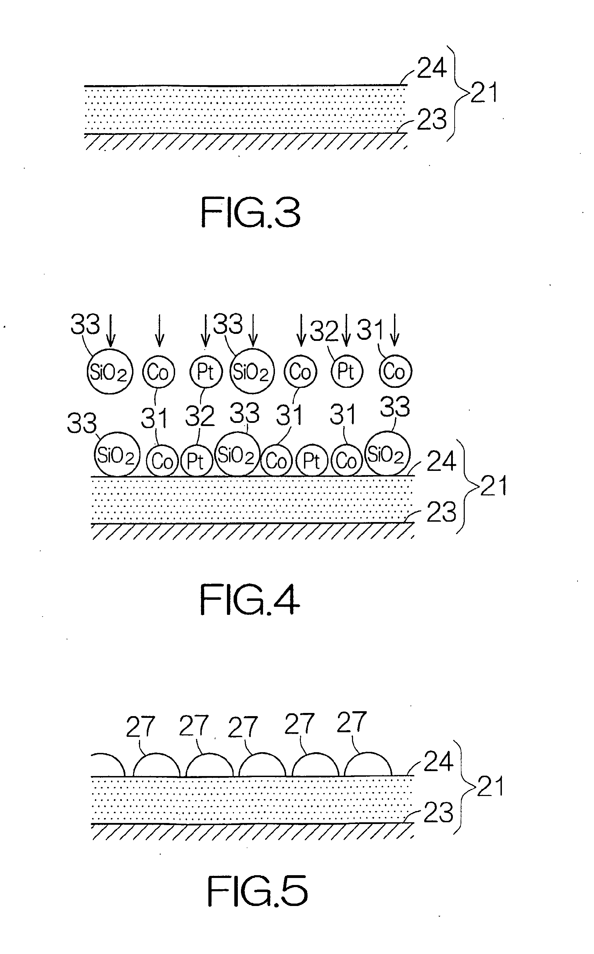

Next, a detailed description will be made of a method of making the magnetic recording disk 13. A disk-shaped substrate 21 is first prepared as shown in Fig. 3. The substrate 21 is set in a sputtering apparatus. A vacuum is established within the chamber of the sputtering apparatus. The substrate 21 is subjected to a heat treatment of 350 degrees Celsius for a duration of 2 (two) minutes. The heat treatment serves to remove atmospheric gases from the surface of the substrate 21. The substrate 21 is then cooled down to the normal or room temperature, such as 15-25 degrees Celsius.

As shown in Fig. 4, Co atoms 31, Pt atoms 32 and SiO₂ molecules 33 are allowed to fall on the surface of the substrate 21 under the vacuum conditions in the sputtering apparatus. The deposition rate (proportional to concentration) of the SiO₂ molecules 33 may be set in a range between 5at% to 20at% of the total amount of the Co atoms 31, the Pt atoms 32 and the SiO₂ molecules 33.

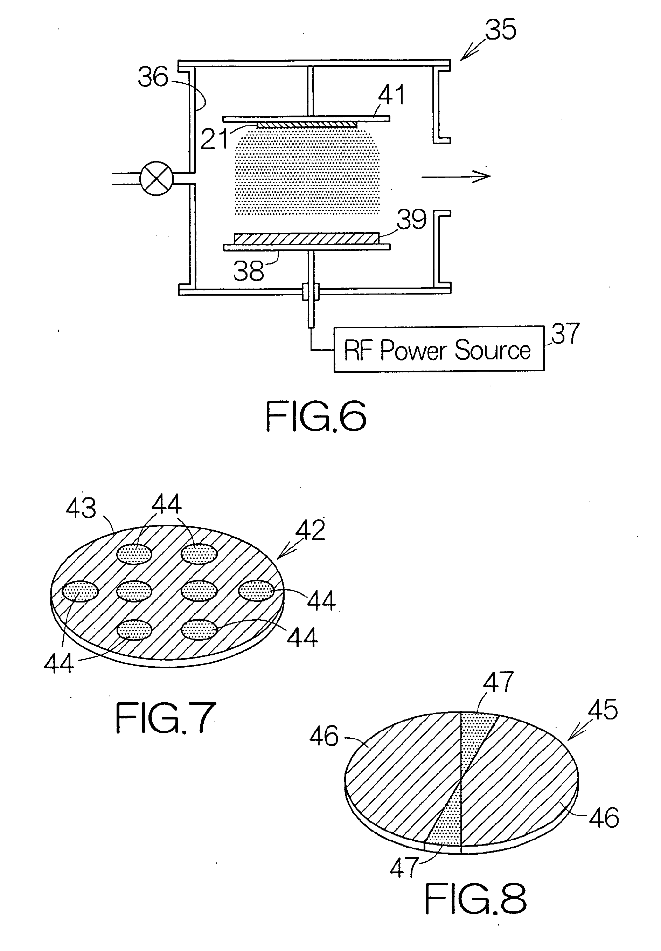

As shown in Fig. 5, the Co atoms 31, the Pt atoms 32 and the SiO₂ molecules 33 form the fine metallic nucleation sites 27 sparsely existing over the surface of the substrate 21. In this case, the substrate 21 is maintained at the normal temperature in the sputtering apparatus. The growth of the individual nucleation sites 27 is restrained. The density of the nucleation sites 27 per unit area can be significantly increased. On the other hand, if the nucleation sites 27 are subjected to heat, the growth of the individual nucleation sites 27 is promoted based on aggregation due to the higher temperature. The individual nucleation sites 27 grow bigger. The nucleation sites 27 are distanced from (separate from) each other.

A brief description will now be made of the structure of a radio frequency sputtering apparatus. As shown in Fig. 6, the sputtering apparatus 35 includes an airtight chamber 36. A cathode 38 and an anode 41 are disposed in the chamber 36. The cathode 38 and the anode 41 are connected to a radio frequency (RF) power source 37. The pressure in the chamber 36 is reduced to 1.33x10⁻⁷[Pa], for example. A vacuum pump, not shown, may be employed to reduce the pressure inside the chamber 36 in this manner. Argon gas is then introduced into the chamber 36. Thereafter, an atmosphere of 4.0x10⁻¹[Pa] is maintained in the chamber 36, for example.

A target 39 is set on the cathode 38. The target 39 may be a powder compact of CoPt and SiO₂, for example. The powders of CoPt and SiO₂ are formed into a compact under a higher pressure. The powder of SiO₂ may be included in the target 39 in a range between 5at% and 20at%. The substrate 21 is mounted on the anode 41.

When the electric power of 300[W] is supplied from the RF power source 37, a high frequency glow discharge is induced between the cathode 38 and the anode 41. The high frequency glow discharge generates the argon plasma. The argon plasma is caused to accelerate because of the reduction in the potential near the cathode 38. The argon plasma is allowed to collide against the surface of the target 39. This type of sputtering apparatus 35 serves to reliably prevent electrification (charging) of an insulator target, for example when the target 39 includes SiO₂. Insulators such as metallic oxides and metallic nitrides are reliably caused to fall on the surface of the substrate 21.

When the high frequency glow discharge has begun, the Co atoms 31, the Pt atoms 32 and the SiO₂ molecules 33 are sputtered out of the target 39. The Co atoms 31, the Pt atoms 32 and the SiO₂ molecules 33 are allowed to fall on the substrate 21 on the anode 41. The Co atoms 31, the Pt atoms 32 and the SiO₂ molecules 33 thus form the fine metallic nucleation sites 27 on the surface of the substrate 21. If the content of SiO₂ drops below 5at%, the formation of the nucleation sites 27 cannot be achieved. On the other hand, if the content of SiO₂ exceeds 20at%, the nucleation sites 27 are covered with the SiO₂ layer. The nucleation sites 27 under the SiO₂ layer cannot contribute to the subsequent growth of the crystal grains. The content of the Co atoms 31, the Pt atoms 32 and the SiO₂ molecules 33 in the nucleation sites 27 corresponds to that of the target 39.

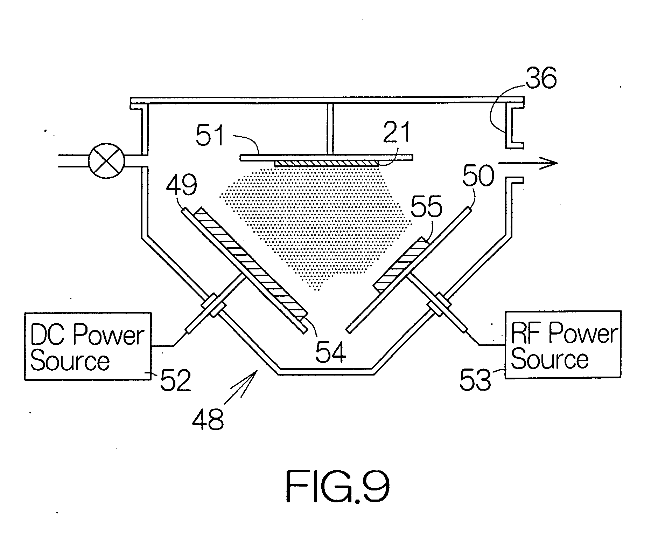

A disk-shaped block 43 of CoPt alloy as shown in Fig. 7 may be employed as a target 42 in the sputtering apparatus 35, for example. Chips 44 of SiO₂ are located on the surface of the block 43. The content of the atoms 31, 32 and the molecules 33 can be determined based on the ratio of the exposed area between the block 43 and the chips 44. Otherwise, a CoPt alloy area 46 and an SiO₂ area 47 may be defined side by side on a target 45, as shown in Fig. 8.

A so-called co-sputtering apparatus may be employed to form the metallic nucleation sites 27. As shown in Fig. 9, the co-sputtering apparatus 48 includes a pair of cathodes 49, 50 and an anode 51 within the chamber 36. The cathode 49 is connected to a direct current (DC) power source 52 while the cathode 50 is connected to a RF power source 53. An electrically conductive CoPt alloy target 54 is set on the cathode 49, for example. An insulating SiO₂ target 55 is set on the cathode 50, for example.

The co-sputtering apparatus 48 allows generation of a direct current glow discharge between the cathode 49 and the anode 51, as well as a high frequency glow discharge between the cathode 50 and the anode 51. The direct current glow discharge causes the Co atoms and the Pt atoms to fall on the surface of the substrate 21 from the target 54. At the same time, the high frequency glow discharge causes the SiO₂ molecules to fall on the surface of the substrate 21 from the target 55. In this manner, the metallic nucleation sites 27 are established on the surface of the substrate 21.

The output power of the DC power source 52 serves to determine the amount of falling Co atoms 31 and Pt atoms 32 in the co-sputtering apparatus 48. Likewise, the output power of the RF power source 53 serves to determine the amount of falling SiO₂ molecules 33. Adjustment of the output powers leads to an easier management of the content within the nucleation sites 27 irrespective of the size or exposed areas of the target 54, 55. The co-sputtering apparatus 48 only requires a pair of targets, independently including a CoPt alloy and SiO₂. If the CoPt alloy versus SiO₂ content is intended to be set at 95:5 in at%, the output power of the DC power source 52 is set at approximately 100W, while the output power of the RF power source 53 is set at approximately 50W, for example. The operation time may be set at 1[sec] in this case.

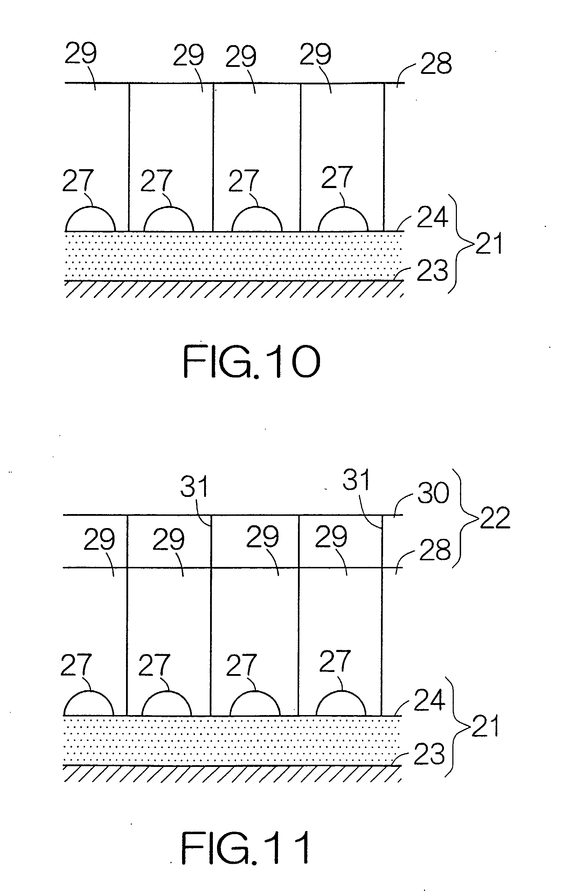

As shown in Fig. 10, Cr atoms are allowed to fall on the substrate 21 after the formation of the nucleation sites 27 has been completed. A Cr layer is thus formed over the surface of the substrate 21. Sputtering may be employed to form the Cr layer, for example. The Cr atoms form the fine crystal grains 29 based on the individual metallic nucleation sites 27 on the substrate 21. A seed crystal layer 28 of 18.0nm thickness can be obtained on the substrate 21 in this manner.

During the formation of the seed crystal layer 28, the substrate 21 is maintained at the normal temperature. Accordingly, aggregation of the nucleation sites 27 is reliably prevented, and the individual nucleation sites 27 are prevented from growing bigger. The fine crystal grains 29 are thus reliably obtained.

As shown in Fig. 11, the magnetic crystal layer 30 is then formed on the surface of the seed crystal layer 28. The magnetic crystal layer 30 comprises a Co90Pt10 layer of 7.8nm, for example. Sputtering may be utilized to form the magnetic crystal layer 30. The Co atoms and the Pt atoms are allowed to fall on the surface of the Cr layer under vacuum conditions. The Co atoms and the Pt atoms are allowed to grow into fine magnetic crystal grains based on the epitaxial relationship with the seed crystal layer 28. The epitaxy serves to define grain boundaries 31 between the adjacent crystal grains 29 within the magnetic crystal layer 30.

Thereafter, the Cr atoms in the seed crystal layer 28 may be forced to diffuse along the grain boundaries 31 within the magnetic crystal layer 30. The diffusion of the Cr atoms forms walls of non-magnetic material along the grain boundaries 31. The layered polycrystalline structure film 22 is obtained in this manner. The protective carbon overcoat 25 of approximately 5.0nm thickness and the lubricating agent film 26 of approximately 1.0nm thickness, for example, are finally formed so as to spread over the exposed surface of the layered polycrystalline structure film 22.

The present inventors have examined the properties of the aforementioned layered polycrystalline structure film 22. The RF power source 37 was employed to effect the sputtering. The target 39 was the powder compact of Co88Pt12 (95at%) and SiO₂ (5at%). A thickness of 0.4nm was set for a CoPt and SiO₂ layer in the sputtering apparatus.

The inventors have also examined a layered polycrystalline structure film according to a comparative example. The substrate of the comparative example was set in the sputtering apparatus after exposure in the normal atmosphere. The Co atoms and the Pt atoms were then allowed to fall on the surface of the substrate under the vacuum conditions. A thickness of 1.0nm was set for a CoPt and SiO₂ layer in the sputtering apparatus in this case. After formation of the CoPt and SiO₂ layer, the substrate was subjected to a heat treatment. Nucleation sites were thus formed on the substrate based on aggregation due to a higher temperature.

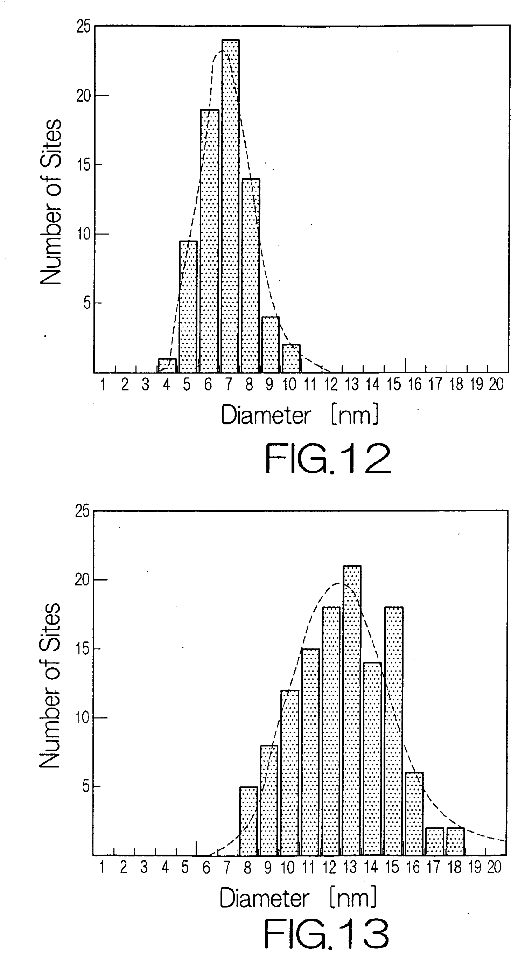

The inventors have measured the diameter of the individual nucleation sites on the surface of the substrate. A transmission electron microscope (TEM) was employed to observe the surface of the substrate. The distribution of the diameters was observed through the image of the TEM. As shown in Fig. 12, an average diameter of 6.8nm was obtained for the metallic nucleation sites 27 of the present embodiment. A variance of 1.2nm was calculated based on the lognormal distribution. The ratio of the variance to the average diameter was 0.18. On the other hand, an average diameter of 12.7nm and a variance of 2.6nm were obtained for the nucleation sites of the comparative example, as shown in Fig. 13. The ratio of the variance to the average diameter was 0.20. These results have demonstrated that the method of the invention significantly enhances (decreases) the ratio of the variance to the average diameter. It has been proved that the fine and smallest crystal grains 29 can be established in accordance with the aforementioned method.

Thus, as described above, the present invention can provide a polycrystalline structure film suitable for use in a magnetic recording medium, comprising: metallic nucleation sites distributed over a surface of a substrate with a high density per unit area, said metallic nucleation sites including a compound; and a metallic crystal layer covering over the surface of the substrate and containing crystal grains having grown from the metallic nucleation sites, wherein the metallic nucleation sites cause minimization of the crystal grains in the polycrystalline structure film.

In addition, the invention can provide a method of making a polycrystalline structure film which includes causing metallic atoms and compounds to deposit over the surface of a substrate. When the metallic atoms and the molecules of the compounds are simultaneously deposited on the substrate, fine and smallest metallic nucleation sites can be formed over the surface of the substrate at a higher density per unit area. Subsequent deposition of metallic atoms enables generation of fine and smallest crystal grains consisting of the metallic atoms.

## Claims

1. A polycrystalline structure film (22) suitable for use in a magnetic recording medium, comprising:
metallic nucleation sites (27) sparsely existing over a surface of a substrate (21), said metallic nucleation sites (27) including a compound; and
a metallic crystal layer (28, 30) covering over the surface of the substrate (21) and containing crystal grains (29) having grown from the metallic nucleation sites (27).

2. A polycrystalline structure film (22) according to claim 1, wherein said compound is a metallic compound.

3. A polycrystalline structure film (22) according to claim 2, wherein said metallic compound includes at least one of a metallic nitride and a metallic oxide.

4. A polycrystalline structure film (22) according to claim 3, wherein said metallic compound is any of Si₃N₄, SiO₂ and Al₂O₃.

5. A polycrystalline structure film (22) according to any preceding claim, wherein said metallic nucleation sites (27) include at least one of platinum atoms and cobalt atoms.

6. A polycrystalline structure film (22) according to any preceding claim, wherein said metallic nucleation sites (27) contain said compound in a range between 5at% and 20at%.

7. A method of making a polycrystalline structure film (22) suitable for use in a magnetic recording medium, comprising: providing metallic nucleation sites (27) sparsely existing over a surface of a substrate (21); and causing metallic atoms and compounds to deposit over the surface of the substrate (21).

8. A method according to claim 7, wherein radio frequency sputtering (35) is employed to cause the metallic atoms and the compounds to fall over the substrate (21).

9. A method according to claim 8, wherein a target (39) of the radio frequency sputtering (35) comprises a composition of a powder compact of the metallic atoms and a powder compact of the compounds.

10. A method according to claim 8, wherein a target (42) of the radio frequency sputtering (35) comprises a block (43) consisting of metallic atoms and chips (44) of the compounds located on a surface of the block (43).

11. A method according to claim 7, wherein DC sputtering (48, 49, 51, 52, 54) is employed to cause the metallic atoms to fall while radio frequency sputtering (48, 50, 51, 53, 55) is employed to simultaneously cause the compounds to fall.

12. A method according to any of claims 7 to 11, wherein said substrate (21) is maintained at a normal temperature when the metallic atoms and the compounds are caused to fall.

13. A method according to any of claims 7 to 12, wherein said substrate (21) is maintained at a normal temperature when crystal grains (29) are grown on the substrate (21) after deposition of the metallic atoms and the compounds.

14. A method according to any of claims 7 to 13, wherein said compounds are metallic compounds.

15. A method according to claim 14, wherein said metallic compounds include at least one of a metallic nitride and a metallic oxide.

16. A method according to claim 15, wherein said metallic compounds are any of Si₃N₄, SiO₂ and Al₂O₃.

17. A method according to any of claims 7 to 16, wherein said metallic atoms include at least one of platinum atoms and cobalt atoms.
